# EUROPEAN PATENT SPECIFICATION

(11) **EP 0 271 533 B1**
(45) Date of publication and mention of the grant of the patent: **12.01.1994**
(21) Application number: 87903803.2
(22) Date of filing: 27.05.1987
(51) Int. Cl.: H05K 13/00, B65D 73/02, B65D 85/42

(54) **ELECTRICAL DEVICE TRANSPORT MEDIUM**
TRANSPORTVORRICHTUNG FÜR ELEKTRISCHE GEGENSTÄNDE
MOYEN DE TRANSPORT POUR DISPOSITIFS ELECTRIQUES

(30) Priority: 27.06.1986 US 879307
(43) Date of publication of application: 22.06.1988
(73) Proprietor: SYM-TEK SYSTEMS, INC., San Diego, CA 92123 (US)
(72) Inventor: O'CONNOR, R., Bruce, San Diego, CA 92131 (US); SWENDROWSKI, Steven, San Diego, CA 92129 (US); TOTH, Thomas, EL Cajone, CA 92025 (US)
(74) Representative: Wilson, Joseph Martin
(86) International application number: US8701245
(87) International publication number: WO8800161

(56) References cited:
- GB-A- 2 053 855
- US-A- 3 444 993
- US-A- 3 673 543
- US-A- 3 772 573
- US-A- 3 809 233
- US-A- 3 946 864
- US-A- 4 012 608
- US-A- 4 015 707
- US-A- 4 210 243
- US-A- 4 442 938
- US-A- 4 483 442
- US-A- 4 657 137
- IBM TECHNICAL DISCLOSURE BULLETIN, vol. 25, no. 11b, April 1983, pages 6123-6125 ; New York, US; H.R. POWELEIT et al.: "MLC substrate holding fixture"
- IBM TECHNICAL DISCLOSURE BULLETIN, vol. 17, no. 6, November 1974, pages 1629-1630 ; New York, US; J.C. FORMICHELLI et al.: "Pallets for handling modules of various sizes"

## Description

### BACKGROUND OF THE INVENTION

This invention relates to a transport medium for the in-processing transportation of electrical devices.

As used herein, the term "electrical device" shall refer to and mean semiconductor devices, integrated circuit devices, hybrid devices and the like. As used herein, the term "backend processing" shall refer to and mean all of the heating, cooling, testing, sorting, marking and other processes which an electrical device undergoes from the time it is assembled to the time it is ready for shipment to a customer.

Generally, assembled electrical devices are transported through the various backend processing machines in one of two ways. One is known as "naked" handling, where no type of eletrical device protection or handling standardization is used. Here, the devices are fed "as is" to a processing machine from a transport medium known as a tube. One tube generally holds 15 to 30 devices depending on the device size. The devices are stacked in the tubes. A typical tube contains twenty-seven 16-pin, 300 mil devices. Generally, the tubes are made of plastic or aluminum. They do not carry any kind of readable tracking identification indicia and are hand-carried, typically in a box or tote , from process step to process step. The devices must be removed from the tubes for each process step on a per machine basis. When a machine has completed a process step (or steps), the devices are returned back into a tube (probably a different tube) to be carried to the next process step. Information containing the results of the last and all previous process steps is usually recorded by hand on a piece of paper (traveler) and is transported with each group (lot) of tubes.

Such conventional processing technology, therefore, is very labor intensive. In large manufacturing facilities workers are needed to transport the tubes of devices from process step to process step. In fact, manufacturing lot sizes are typically limited to the number of devices that one operator can carry by hand. Many times, the integrity of the results of a process step is dependent on where the operator places a tube of processed devices. Misplacing a tube can easily compromise the integrity of a lot. In addition, information associated with the lot is usually carried on paper with the devices and must be hand entered at each process step by the operator. This requires additional skilled operators and further allows for human error to be introduced.

Other problems with conventional backend processing are associated with loading and unloading the devices in tubes for each process step. Naked handling allows mechanical defects (bent leads, chips, etc.) and electrostatic discharge failures. Bent leads, in turn, can cause the various process machines to jam up.

Further problems are associated with the processing machines themselves. Since each machine must unload and reload the devices into the tubes, each machine must be adapted to a particular device form. Besides the expense of having such device specific machines, such adapted machines are quite prone to failure, (e.g. jams, mis-processing) due to minor fluctuations in device form and wear associated with high volume handling. Furthermore, the electrical devices manufacturer is burdened by having to maintain various pieces of equipment that are dedicated to a particular device package form.

The other method incorporates the use of a "carrier". The devices are placed in a plastic frame to protect the contact leads and to provide limited handling standardization. These carriers, with the devices installed, are also fed to the machine in tubes.

Carriers reduce mechanical defects and reduce package specific handling to some extent. But, carriers still cause jams due to wearing of the relatively soft plastic from which the carriers are made. Furthermore, handling standardization only occurs across common package styles with similar lead counts (ie. 14-18 lead DIPs or 68-88 lead PGAs).

U.S. Patent No 3673543 discloses a receptacle for a micro-circuit pack comprising a U-shaped body with a plurality of apertures therein, the aperture being adapted to accommodate the leads of the micro-circuit pack. This device is intended to facilitate connection of the micro-circuit pack to other parts of a computer via a wire-wrap panel.

Backend processing by this invention eliminates the tube. In the preferred embodiment as will be described, the electrical devices, up to 256 of them, are latched into seats defined by a planar tray, the seats being coordinately arranged, such as in a standard X-Y format. The tray is the common transport medium for the devices to and from all processing equipment, and during all processing. Preferably the seats of a tray can be configured to accommodate a wide variety of device package forms, while not changing the outside dimensions of the tray. This standardizes the processing equipment and minimizes their dependence on changing package types.

The devices are loaded into a tray one time and then the tray is used as the transport medium throughout the backend processing. This eliminates the need to handle the devices individually at each process step and thereby standardizes the equipment and greatly improves their reliability. The possibility of damage to the devices is vastly reduced as they are never touched by human hands, and the number of machine insert ions are reduced to a minimum because full trays of devices are inserted rather than individual devices. Also, since each device in a tray occupies a unique position in a coordinate system, each device can be uniquely identified at each process step. Thus, the traceability and reliability of device process information is vastly improved over conventional methods.

This invention will allow an electrical device manufacturer to totally automate his or her line with minimal set-up changes to run a wide variety of products. The devices can be automatically conveyed to their appropriate process steps under the direction of a process control system. Then they can be loaded and unloaded using a mechanism such as an automated loading arm. The load arm might consist of an X-Y-Z positioning matrix, or it might be a commercially available robot arm. Lot sizes can be optimized to implement a just-in-time approach to manufacturing. Material queues can be reduced through faster set-up times and line flexibility.

Other advantages and attributes of this invention will be discussed in, or will be readily discernible upon a reading of, the text hereinafter.
According to the present invention there is provided a transport medium for in-processing transportation of electrical devices comprising:
a) a plurality of carrier units for carrying at least one electrical device, each in a way that the top and the bottom of each carried electrical device is exposed to enable processing it while it is being carried in its respective carrier unit; and
b) frame means adapted to hold the carrier units in a generally co-planar relationship throughout the processing characterized in that:
c) the frame means is a generally planar sheet,
d) the carrier units are held in fixed relation across a plane of said co-planar relationship by means affixing each carrier unit in a respective carrier unit hole, defined by the frame means (2)
e) the means affixing each carrier unit in its respective carrier unit hole is adapted to allow the carrier unit to float normal to the general plane of the frame means,
f) a plurality of planarization posts project from a base of each carrier unit, and
g) the transport medium further comprises a frame support means adapted to rest on a lower level of a bi-level processing platform and space the frame means above an upper level of the platform by an amount by which the carrier units affixed in said frame means rest entirely on their respective planarization posts which rest upon the upper level of the platform.

Preferably the planarization posts also act as means for exposing the top and bottom of each electrical device carried by each carrier unit. The means for holding the carrier units may hold the carrier units uniformly oriented.

The means for holding the carrier units may comprise the frame means, a plurality of generally co-planar holes defined by the frame means in which the carrier units are disposed and means for sealing the carrier units in their respective holes but allowing the carrier units to float with respect to the plane of the holes.

Preferably the means for securing the carrier units in their respective holes comprises:
a) a plurality of prong means projecting from a base of each carrier unit, each prong means having a resiliently and radially collapsible barbed end, and
b) a plurality of corresponding catch holes defined by the frame means, the size of each catch hole being less than the size of the uncollapsed barbed end of a corresponding prong means but being large enough to allow passage therethrough of the collapsed barbed end so as to catch the barbed ends when the prong means is inserted into the catch hole.

Each carrier unit may comprise:
a) a perimeter which is uniform with the perimeters of the other carrier units, and
b) a core which is specially adapted to a particular electrical device size and form.

The core preferably further comprises:
a) one or more electrical device seats in which the electrical devices are seated,
b) means for aligning a processing probe with the electrical devices seated in the carrier unit, and
c) a web means affixed to the carrier unit perimeter (54) for holding the device seat or seats and the means for aligning a processing probe in fixed relation to the core, any plurality of device seats being fixed in co-planar relationship.

Each electrical device seat may comprise:
a) a seat sleeve conforming to a marginal size and form of an electrical device which is seatable therein,
b) a stop means intruding into the seat sleeve for limiting the depth at which the electrical device is seated, and
c) a plurality of resiliently retractable hook means operatively opposed to the stop means for grasping the electrical device therebetween.

The carrier unit holes may be coordinately disposed to enable the carrier units disposed therein to be uniquely identifiable by a set of coordinates and further comprising a frame indexing means for use by a process machine in locating each individual carrier unit according to its coordinates.

An object of this invention is to provide a standardized transport medium for electrical devices to, from and during backend processing steps.

A further object of this invention is to provide a transport medium for electrical devices which, throughout the course of backend processing, can be uniquely identified and which carries the devices in such a way that each carried device can be uniquely identified.

A further object of this invention is to provide a transport medium for electrical devices which exposes a top and a bottom side of each device sufficiently to eliminate the necessity for removing the devices from the transport medium during all backend processing.

A further object of this invention is to provide a transport medium for electrical devices which can be configured to carry a wide variety (much wider than is conventionally possible) of devices of different form while maintaining as a constant the outer dimensions of the medium.

A further object of this invention is to provide a standardized, electrical device carrier (frame means) adapted to carry a plurality of subcarriers (carrier unit) with standardized perimeters, the subcarriers being configurable to carry therein a wide variety (much wider than is conventionally possible) of devices of different form, the subcarriers providing sufficient access to the devices being carried such that the devices can remain in the subcarriers throughout backend processing.

Other objects of this inventions are expressly or impliedly stated in the text of this specification.

### BRIEF DESCRIPTION OF THE DRAWINGS

Figure 1 is a perspective view of a frame means.

Figure 2 is a perspective view of a carrier unit adapted to carry electrical devices, one of which is shown in exploded view.

Figure 3 is a perspective view of a reverse side of the carrier unit of figure 2.

Figure 4 is an enlarged portion of figure 3.

Figure 5 is a section taken along line 5-5 of figure 2.

Figure 6 is a section taken along line 6-6 of figure 2.

Figure 7 is a sectional view showing the loading of a device into a carrier unit.

Figure 8 is a partial sectional view showing the removal of a carrier unit from the frame means.

Figure 9 is a perspective view of a standardized carrier unit perimeter.

Figure 10 is a perspective view of a carrier unit of the kind shown in figures 1-3.

Figure 11 is a perspective view of a carrier unit adapted for a different kind of device.

### DESCRIPTION OF THE PREFERRED EMBODIMENT

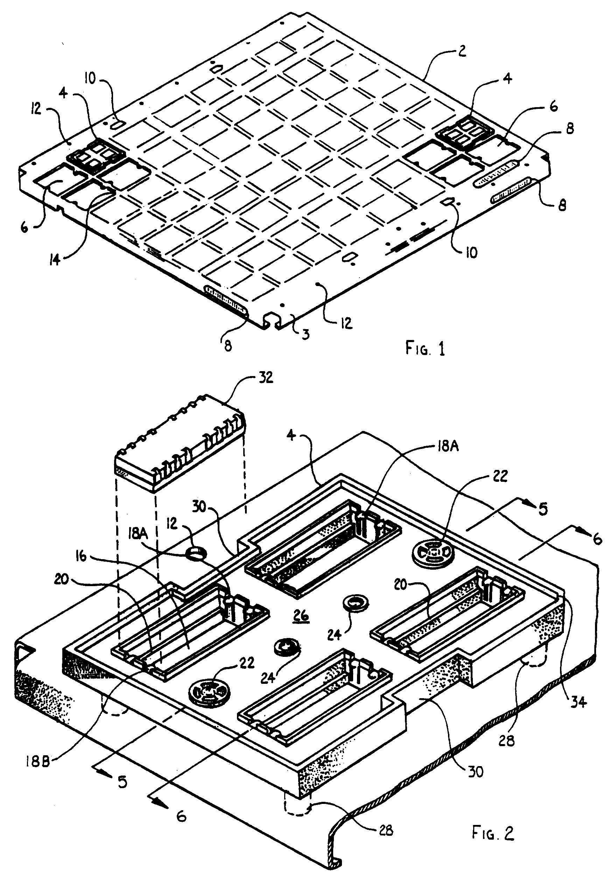

Referring to figure 1, a generally planar frame 2 with uniformly right-angled margins 3 is shown to carry a plurality of generally rectangular carrier units 4. The carrier units are adapted to fit into and mate with carrier unit holes 6 defined by the frame 2 and preferably arranged in rows and columns as shown. The frame also has identification indicia 8 on at least three viewing planes. Preferably the indicia comprises a computer-readable bar code in relief, in relief so that the bars do not protrude beyond the sides of the frame. Integral with the frame are means 10 for making the frame robotically manipulable, preferably said means comprise receptacle holes defined by the frame and adapted, for example, for use by a robotic end effector.

Referring again to figure 1, along the perimeter of the frame 2 are defined a series of uniformly disposed holes 12. The holes are disposed so as to be on the center lines of each line of carrier units. These holes 12 are preferably used for frame indexing by a process machine, that is, the carrier units are located and identified by the holes. This can be done by using some sort of a "walking beam" mechanism conventionally known. The holes 12 can also be used for frame alignment. There is also an orientation means by which the carrier units are oriented when they are put in the frames. As can be seen, the carrier unit holes 6 are generally rectangular with one corner 14 being beveled. As will be explained, said beveled corner matches and mates with a notched corner of the carrier units 4 to indicate proper orientation of the carrier units.

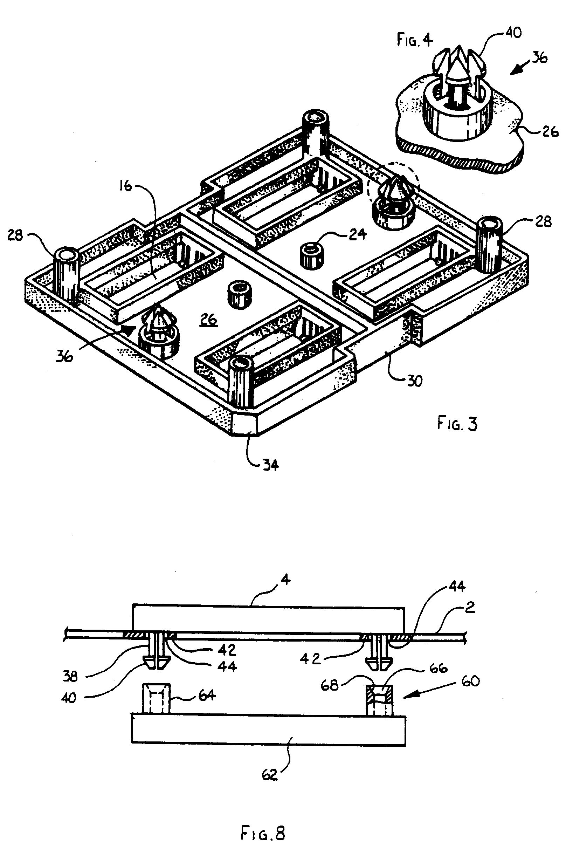

Referring to figures 2 and 3, a more detailed showing of a carrier unit 4 is presented figure 2 being a topside view of a carrier unit 4 disposed in a frame 2 and figure 3 being an underside view of the carrier unit. The carrier unit as shown in these figures defines four electrical device seats 16. Each seat comprises a sleeve open at both top and bottom, the sleeves conforming to the marginal size and form of a particular type of electrical device as will be explained. The devices are loaded into the seats and are latched therein by a plurality of device latches 18a and 18b. The device latches are generally in the form of an inverted "L" with the base leg of the "L" being used to hook the device and hold it against a stop which is a seating plant or shoulder 20 intruding into the sleeve. Preferably two latches 18A hook one end of a device and two latches 18B hook an opposite end of the device, the latches operatively opposed to the stop to hold the device therebetween. A plurality of alignment holes 22 and 24, which are defined by sleeves protruding through a web 26, are used to precisely locate within a carrier unit the seated devices for a processing probe or marker. The web 26 is the interconnecting structure which ties seat walls, sleeves, and a carrier unit perimeter wall together in place. Projecting from a base of each carrier unit are four planarization posts 28. The purpose of the posts will be more fully explained later. The long sides of the carrier units are centrally and transversally indented to form receptacles 30 which are adapted to being gripped by a robotic end effector. The receptacles 30 provide a means by which the carrier units can be automatically loaded into a frame with conventional pick-and-place equipment or robots such as the Seiko RT-2000 or the IBM 7535 machines. An electrical device 32 having sixteen contacts or leads is shown exploded from a carrier unit seat 16 and is oriented reverse-side-up as it would be disposed within the carrier unit. The carrier unit is also shown to have a notched corner 34 which matches the beveled corner 14 of the frame. The matching of the notch and bevel indicate that the carrier unit is properly oriented within the frame.

Referring to figures 3 through 5, the details and use of carrier unit retention latches, generally designated 36, are shown. A plurality of resilient prongs 38 of a carrier unit retention latch 36 are uniformly and angularly spaced around an imaginary circle, each prong having an outwardly tapered barbed end 40. The prongs of each carrier unit retention latch are so disposed that they appear to be spaced-apart slats of an imaginary hollow cylinder and the barbed ends appear to be wedges of a conical arrowhead atop the cylinder, the cylinder inside diameter being an extension of the alignment hole 22. The prongs of each carrier unit retention latch are adapted to radially collapse together whenever the barbed ends are inserted into a catch hole too small for the cone of the barbed ends to freely pass through. In such a case, the taper of the barbed ends act as cams riding against the rim of the hole forcing the barbed ends of the prongs to radially move together. Once through the hole, the prongs resiliently return to their spaced-apart positions if the diameter of the hole is at least equal to the outer diameter of the prong cylinder. The resiliency of the prongs are functions of the design length of the latch beam and the prong material's flexural modulus. The fact that the inside diameter of the prongs' cylinder is an extension of alignment hole 22 saves space on the carrier unit face. The extension simultaneously provides an alignment hole and clearance for the prongs to collapse together.

Preferably, each carrier unit has a pair of integral carrier unit retention latches 36 oppositely and centrally disposed proximate the short ends of the carrier unit. When loading a carrier unit into the frame, the pair of latches are forced through a corresponding pair of catch holes 44 defined by a pair of flanges 42 integral with the frame. The flanges are extensions of the frame which project into the carrier unit hole 16. The diameter of the catch holes 44 are greater than the outer diameter of the prong cylinder but less than the largest outer diameter of the cone of the barbed ends. The barbed ends prevent removal of the carrier unit without the use of a removal tool as will be described.

The length of the prongs 38 is adapted to provide a suitable amount of carrier unit 4 travel normal to the general plane of the frame. In other words, the length of the prongs from a base of the carrier unit to the barbed end of the prongs is sufficiently greater than the thickness of the flanges 42 to enable the carrier units to effectively "float" on the frame.

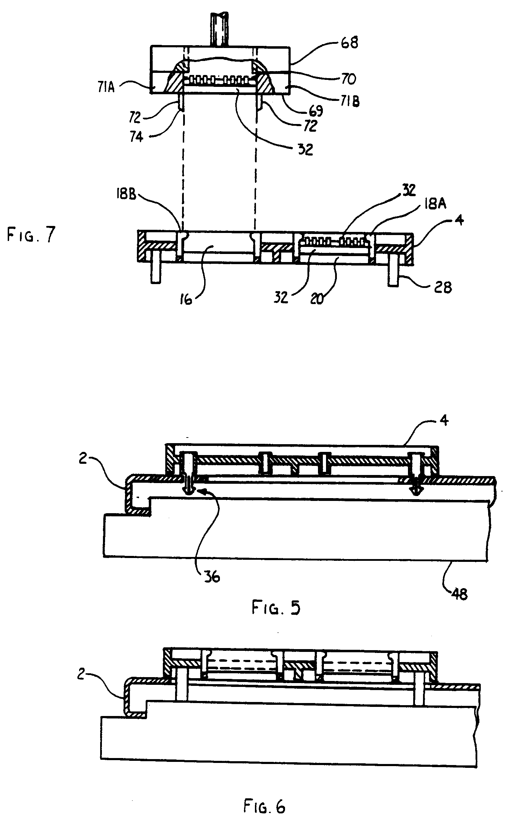

Referring to figures 5 and 6, a frame 2 and a carrier unit 4 are shown to be disposed upon a bi-level process machine platform 48 having two reference planes. The frame is supported by its angled margin 3 resting upon the lower reference plane, while the amount of carrier unit travel normal to the frame is sufficient to allow the carrier unit to rest entirely on its planarization posts 28 which are resting on the upper reference plane. Preferably the differential between the upper and lower reference planes, the length of the planarization posts, and the amount of carrier unit travel are set so that when the frame is seated on the lower plane of the platform 48, all the carrier units are raised up slightly from the frame by the upper plane of the platform, approximately .030 inches. This brings all of the carrier units and their seated electrical devices up to a common working plane, even if the frame is slightly warped. This has the effect of precisely placing the upward facing contacts of all devices on the frame in a common plane, i.e., causing the z-axis coordinate of all of the devices to be the same even though the frame may be slightly warped. The "floating" of the carrier units with respect to the frames is particularly advantageous because the planarity of the frames need not be precisely controlled as would otherwise be the case and only the planarity of the process machines' platforms need to be tightly controlled.

To load the electrical devices, the frame could be mounted on an X-Y table and indexed under some type of insertion head containing the device to be loaded. Once a device is centered over a device seat then the insertion head pushes the device past the device retention latches, 18A and 18B, and seats it. It should be noted that the devices are totally recessed into the carrier units to virtually eliminate accidental leading bending after it is loaded. An alternative loading method would be to first retract the device retention latches with some latch retraction means on the insertion head, then simply drop the device. The latches would then spring back and retain the device after the insertion head is withdrawn. Unloading the devices can be accomplished by reversing the sequence in the aforementioned methods. The only differences are that the device would be pushed from the opposite side of the frame to overcome the device retention latch force, or a vacuum pick would be used to remove the devices in the alternative method.

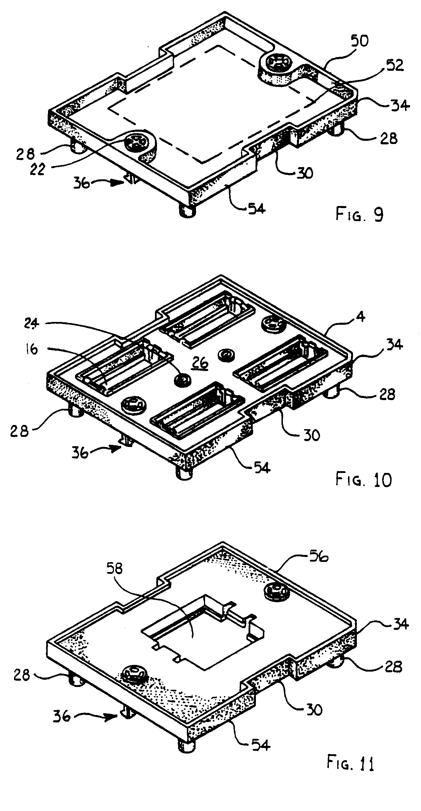

Referring to figure 7, an insertion head having a body 68 with a facing 69 is shown in the act of inserting a first electrical device 32 into a first device seat 16 while a second device is shown already seated in a second seat. The insertion head has a device-holding cavity 70 open to the facing 69 into which the device-to-be-loaded is placed with the leads of the device being generally oriented inboard for proper subsequent orientation of the device in the seat 16. In one embodiment the cavity 70 is defined by the body 68 and the device is held by a vacuum means in the cavity 70 until it is released and loaded into the seat. In a second embodiment, the cavity 70 is defined by a pair of adjustable or biased jaws 71A and 71B and the device is ejected by releasing it and allowing it to drop. Projecting normally from the facing 69 are a pair of tine means 72A and 72B, each tine having a beveled end 74. The tines are disposed at opposite ends of the device holding cavity, the ends which correspond to the device ends which will be hooked by the device latches 18A and 18B. The tines are so disposed and adapted that as the facing 69 is brought to bear against the topside of the carrier unit 4 in alignment with the seat 16, the beveled tine ends act as cams against the base legs 19A and 19B of the device latches forcing the latches to retract to allow clear passage of the device between said legs and into and out of the seat, the latches 18A and 18B being resilient and their resiliency being functions of their material's flexural modulus.

Referring to figure 8, a carrier unit removal tool, generally designated 60, is shown having a body 62 from which normally project a plurality of posts 64. The number and disposition of the posts 64 correspond to the number and disposition of carrier unit retention latches 36 of a carrier unit 4 being removed from a frame 2, that is, they match in number and the posts are simultaneously alignable with the latches. Each post defines at its free end a centered, inverted cconical hole 66. To remove a carrier unit, the posts are brought to forcibly bear against the barbed ends 40 of the latches. The slopes 68 and the dimensions of the conical hole 66 are adapted to partially receive and force together the barbed ends sufficiently to enable the barbed ends to be pulled though the catch holes 44, and thus releasing the carrier unit from the frame.

Referring to figure 9, a perimeter 50 common to all carrier unit variations is shown having a personality core 52 and wall 54. A significant advantage of this invention is that a wide range of electrical device types and forms can be handled without a variation in the basic outside perimeter and retention latches of the carrier units. It is only the personality core that changes. The core of figure 9 is shown in blank. The dashed line 52 shows generally the area of the core which is personalizable.

Referring to figure 10, the previously discussed carrier unit 4 is shown to illustrate that its perimeter wall 54, carrier unit retention latches 36 and planarization posts 28 are the same as those shown in figure 9. In this case, however, a personality core has been added comprising the web 26, the seats 16 and the alignment holes 24.

Referring to figure 11, a second variation 56 of a carrier unit is shown. Its perimeter, carrier unit retention latches, and planarization posts are identical to those carrier units of figures 9 and 10. Only the personality core is different. It comprises of a web 57 defining a single seat 58, and adapted to carry an electrical device packaged in a form commonly known as pin grid array (PGA).

It should be noted that each device seat defined by a carrier unit can be open at both top and bottom so as to expose a top and a bottom side of a seated device sufficiently to eliminate any necessity for removing the device from its carrier unit during backend processing.

In a backend processing operation, a frame is set up by latching into it carrier units suitable for the form of the electrical devices which will be processed. The devices are then loaded into the carrier units and remain there throughout the processing. The frame is then transported by conveyor belt or other appropriate means to and from the steps of the processing. Access to the device can be gained both from above the frame and below. Preferably the devices are disposed in the carrier units "dead bug" fashion, that is, with their leads generally oriented upward. Processing machine contactors can thus make contact with each device from above the frame. As explained before, all of the devices' leads will be in a common plane when the frame is mounted on a process platform as shown in figures 5 and 6. Thus devices may be electrically contacted singly or in multiples simultaneously. Since each frame is uniquely marked, and a device's position on the frame is constant and can be uniquely identified, processing results about each individual device can be easily and unambiguously maintained. The devices can be marked from either side of the frame. The devices are not unloaded until all process steps are completed, and at that point the unique identifiability of each device can be used to precisely sort them.

The material of the carrier units preferably is selected to resist high temperature deformities, static build up and be highly resistive. One such material is a high temperature, graphite-loaded thermoplastic known as polyethersulfone. It contains graphite fibers to drain off any static build up that can cause electrostatic discharge damage to the devices. The resistivity of the material is preferably held to between 10⁹ - 10¹⁴ ohms per square inch. The high temperature properties of the polyethersulfone enable the loaded frames to carry the devices throughout all heating and cooling chambers commonly known as "soak" chambers. The material's trade name is VICTREX manufactured by ICI Americas, Inc., Wilmington, Delaware.

Although the preferred embodiment disclosed herein includes floating carrier units that are removably latched into the frame, it should be understood that in other embodiments the carrier units can be non-removably affixed into the frame means by rivet or other suitable means in place of te carrier unit retention latches. Furthermore it may be desireable in certain processing environments not to float the carrier units, and the carrier unit retention latches can be shortened to eliminate the floating travel, or the carrier units can be otherwise affixed to the frame by bolt, rivet or other suitable means. Furthermore, the carrier units can be an integral part of the frame.

The foregoing description and drawings were given for illustrative purposes only, it being understood that the invention is not limited to the emodiments disclosed, but is intended to embrace any and all alternatives, equivalents, modifications and rearrangements of elements falling within the scope of the invention as defined by the following claims.

## Claims

1. A transport medium for in-processing transportation of electrical devices comprising:
a) a plurality of carrier units (4;56) for carrying at least one electrical device (32), each in a way that the top and the bottom of each carried electrical device (32) is exposed to enable processing it while it is being carried in its respective carrier unit; and
b) frame means (2) adapted to hold the carrier units (4;56) in a generally co-planar relationship throughout the processing characterized in that:
c) the frame means (2) is a generally planar sheet,
d) the carrier units (4;56) are held in fixed relation across a plane of said co-planar relationship by means (36,44) affixing each carrier unit (4;56) in a respective carrier unit hole (6) defined by the frame means (2),
e) the means (36,44) affixing each carrier unit (4;56) in its respective carrier unit hole (6) is adapted to allow the carrier unit (4;56) to float normal to the general plane of the frame means (2),
f) a plurality of planarization posts (28) project from a base of each carrier unit (4;56), and
g) the transport medium further comprises a frame support means (3) adapted to rest on a lower level of a bi-level processing platform (48) and space the frame means (2) above an upper level of the platform (48) by an amount, by which the carrier units (4;56) affixed in said frame means (2) rest entirely on their respective planarization posts (28), which rest upon the upper level of the platform (48).

2. The transport medium according to claim 1, wherein the planarization posts (28) also act as means for exposing the top and bottom of each electrical device (32) carried by said each carrier unit (4;56).

3. The transport medium according to claim 1 or 2, wherein the means (2) for holding the carrier units (4;56) holds the carrier units uniformly oriented.

4. The transport medium according to claims 1, 2 or 3, wherein the means (2) for holding the carrier units comprises:
a) the frame means (2),
b) a plurality of general co-planar holes (6) defined by the frame means (2) in which the carrier units (4;56) are disposed, and
c) means (38,40) for securing the carrier units (4;56) in their respective holes (6) but allowing the carrier units (4;56) to float with respect to the plane of the holes (6).

5. The transport medium according to claim 4, wherein the means (38,40) for securing the carrier units (4;56) in their respective holes (6) comprises:
a) a plurality of prong means (38) projecting from a base of each carrier unit (4;56), each prong means (38) having a resiliently and radially collapsible barbed end (40), and
b) a plurality of corresponding catch holes (44) defined by the frame means (2), the size of each catch hole (44) being less than the size of the uncollapsed barbed end (40) of a corresponding prong means (38) but being large enough to allow passage therethrough of the collapsed barbed end so as to catch the barbed ends when the prong means is inserted into the catch hole (44).

6. The transport medium according to any one of the preceding claims, wherein each carrier unit (4;56) further comprises:
a) a perimeter (54) which is uniform with the perimeters of the other carrier units, and
b) a core (52) which is specially adapted to a particular electrical device size and form.

7. The transport medium according to claim 6, wherein the core (26;57) further comprises:
a) one or more electrical device seats (16;58) in which the electrical devices (32) are seated,
b) means for aligning a processing probe with the electrical devices seated in the carrier unit, and
c) a web means affixed to the carrier unit perimeter (54) for holding the device seat or seats (16;58) and the means for aligning a processing probe in fixed relation to the core (52), any plurality of device seats being fixed in coplanar relationship.

8. The transport medium according to claim 7, wherein each electrical device seat (16;58) comprises:
a) a seat sleeve conforming to a marginal size and form of an electrical device (32) which is seatable therein,
b) a stop means (20) intruding into the seat sleeve for limiting the depth at which the electrical device (32) is seated, and
c) a plurality of resiliently retractable hook means (18a,18b) operatively opposed to the stop means (20) for grasping the electrical device (32) therebetween.

9. The transport medium according to claim 4, wherein the carrier unit holes (6) are coordinately disposed to enable the carrier units disposed therein to be uniquely identifiable by a set of coordinates, and further comprising a frame indexing means (12) for use by a process machine in locating each individual carrier unit according to its coordinates.

## Patentansprüche

1. Transporteinrichtung zum Transport von elektrischen Vorrichtungen während einer Behandlung mit
a) mehreren Trägereinheiten (4; 56), die wenigstens eine elektrische Vorrichtung (32) jeweils so tragen, daß die Ober- und die Unterseite jeder getragenen elektrischen Vorrichtung (32) freiliegt, damit sie behandelt werden kann, während sie in ihrer jeweiligen Trägereinheit getragen wird; und
b) einer Rahmeneinrichtung (2), die dazu geeignet ist, die Trägereinheiten (4; 56) während der Behandlung in einer insgesamt koplanaren Beziehung zu halten, dadurch gekennzeichnet, daß
c) die Rahmeneinrichtung (2) eine insgesamt ebene Platte ist,
d) die Trägereinheiten (4; 56) durch eine Einrichtung (36, 44) in einer festen Relation über einer Ebene der koplanaren Beziehung gehalten werden, die jede Trägereinheit (4; 56) in einer jeweiligen Trägereinheitsöffnung (6) festlegt, die durch die Rahmeneinrichtung (2) gebildet wird,
e) die Einrichtung (36, 44), die jede Trägereinheit (4; 56) in ihrer jeweiligen Trägereinheitsöffnung (6) festlegt, dazu geeignet ist, daß die Trägereinheit (4; 56) senkrecht zur Gesamtebene der Rahmeneinrichtung (2) verschiebbar ist,
f) von dem Boden jeder Trägereinheit (4; 56) mehrere Nivellierungsstützen (28) vorstehen, und
g) die Transporteinrichtung außerdem eine Rahmentransporteinrichtung (3) umfaßt, die auf einer unteren Ebene einer Behandlungplattform (48) mit zwei Ebenen aufliegen kann und die Rahmeneinrichtung (2) soweit über einer oberen Ebene der Plattform (48) in Abstand hält, daß die in dem Rahmen (2) festgelegten Trägereinheiten (4; 56) vollkommen auf ihren jeweiligen Nivellierungsstützen (28) liegen, die auf der oberen Ebene der Plattform (48) aufliegen.

2. Transporteinrichtung nach Anspruch 1, dadurch gekennzeichnet, daß die Nivellierungsstützen (28) auch als Einrichtung zur Freilegung der Ober- und Unterseite jeder elektrischen Vorrichtung (32) wirken, die von jeder Trägereinheit (4; 56) getragen wird.

3. Transporteinrichtung nach Anspruch 1 oder 2, dadurch gekennzeichnet, daß die Einrichtung (2) zum Halten der Trägereinheiten (4; 56) die Trägereinheiten einheitlich ausgerichtet hält.

4. Transporteinrichtung nach Anspruch 1, 2 oder 3, bei der die Einrichtung (2) zum Halten der Trägereinheiten umfaßt:
a) die Rahmeneinrichtung (2),
b) mehrere von der Rahmeneinrichtung (2) gebildete, insgesamt koplanare Öffnungen (6), in denen die Trägereinheiten (4; 56) angeordnet sind, und
c) Einrichtungen (38, 40), die die Trägereinheiten
(4; 56) in ihren jeweiligen Öffnungen (6) befestigen, jedoch eine Verschiebung der Trägereinheiten (4; 56) bezüglich der Ebene der Öffnungen (6) ermöglichen.

5. Transporteinrichtung nach Anspruch 4, dadurch gekennzeichnet, daß die Einrichtung (38, 40) zur Befestigung der Trägereinheiten (4; 56) in ihren jeweiligen Öffnungen (6) umfaßt:
a) mehrere Stifteinrichtungen (38), die von einem Boden jeder Trägereinheit (4; 56) vorstehen, wobei jede Stifteinrichtung (38) ein elastisches und radial zusammendrückbares Ende (40) mit Widerhaken aufweist, und
b) mehrere entsprechende Arretieröffnungen (44), die durch die Rahmeneinrichtung (2) gebildet werden, wobei jede Arretieröffnung (44) kleiner ist als das nicht zusammengedrückte Ende (40) mit Widerhaken einer entsprechenden Stifteinrichtung (38), jedoch groß genug ist, damit das zusammengedrückte Ende mit Widerhaken hindurchgehen kann, um die Enden mit Widerhaken zu arretieren, wenn die Stifteinrichtung in die Arretieröffnung (44) eingesetzt ist.

6. Transporteinrichtung nach einem der vorhergehenden Ansprüche, bei dem die Trägereinheit (4; 56) außerdem umfaßt:
a) einen Umfang (54), der gleich den Umfängen der anderen Trägereinheiten (54) ist, und
b) einen Kern (52), der speziell an die Größe und Form einer bestimmten elektrischen Vorrichtung angepaßt ist.

7. Transporteinrichtung nach Anspruch 6, dadurch gekennzeichnet, daß der Kern (26; 57) außerdem umfaßt:
a) eine oder mehrere Aufnahmen (16, 58) für eine elektrische Vorrichtung, in die die elektronischen Vorrichtungen (32) eingesetzt werden,
b) Einrichtungen zur Ausrichtung eines Meßfühlers für die Behandlung zu den in die Trägereinheit eingesetzten elektrischen Vorrichtungen, und
c) einer am Umfang (54) der Trägereinheit befestigten Stegeinrichtung, die die Aufnahme oder Aufnahmen (16; 58) der Vorrichtung und die Einrichtung zur Ausrichtung eines Meßfühlers für die Behandlung in einer festen Beziehung zu dem Kern (52) hält, wobei mehrere Aufnahmen für die Vorrichtung in einer koplanaren Beziehung befestigt sind.

8. Transporteinrichtung nach Anspruch 7, bei dem jede Aufnahme für eine elektrische Vorrichtung (16; 58) umfaßt:
a) eine Aufnahmebuchse, die konform zur Randgröße und -form einer elektrischen Vorrichtung (32) ist, die in ihr aufgenommen werden kann,
b) eine Anschlagseinrichtung (20), die in die Aufnahmebuchse vorsteht, um die Tiefe zu begrenzen, in der die elektrische Vorrichtung (32) eingesetzt ist, und
c) mehrere elastische zurückziehbare Hakeneinrichtungen (18a, 18b), die der Anschlageinrichtung (20) wirksam gegenüberliegen, um die dazwischenbefindliche elektronische Vorrichtung (32) zu fassen.

9. Transporteinrichtung nach Anspruch 4, bei dem die Trägereinheitsöffnungen (6) koordiniert angeordnet sind, damit die darin angeordneten Trägereinheiten durch einen Koordinatensatz eindeutig identifizierbar sind, und außerdem eine Rahmenindexierungseinrichtung (12) umfaßt, die von einer Prozeßmaschine zur Lokalisierung jeder einzelnen Trägereinheit entsprechend ihren Koordinaten verwendet wird.

## Revendications

1. Moyen de transport pour le transport en cours de traitement de dispositifs électriques comportant :
a) un ensemble d'unités porteuses (4;56) pour porter au moins un dispositif électrique (32), chacun de telle sorte que le dessus et le dessous de chaque dispositif électrique porté (32) est exposé pour permettre son traitement alors qu'il se trouve porté dans son unité porteuse correspondante ; et
b) un moyen formant châssis (2) susceptible de porter les unités porteuses (4;56) les unes avec les autres dans sensiblement le même plan pendant le traitement, caractérisé en ce que :
c) le moyen formant châssis (2) est une feuille généralement plane,
d) les unités porteuses (4;56) sont supportées en relation fixe dans le plan de cette relation dans le même plan par des moyens (36,44) fixant chaque unité porteuse (4;56) dans un orifice correspondant d'unités porteuses (6) défini par le moyen formant châssis (2),
e) les moyens (36,44) servant à fixer chaque unité porteuse (4;56) dans son orifice d'unité porteuse correspondant (6) est susceptible de permettre à l'unité porteuse (4;56) de flotter perpendiculairement par rapport au plan du moyen formant châssis (2),
f) un ensemble de piliers de planarisation (28) font saillie par rapport à une base de chaque unité porteuse (4;56), et
g) le moyen de transport comporte en outre un moyen support de châssis (3) susceptible de reposer sur un niveau inférieur d'une plate-forme de traitement à deux niveaux (48) et sert à espacer le moyen formant châssis (2) au dessus du niveau supérieur de la plate-forme (48) d'une quantité selon laquelle les unités porteuses (4;56) fixées dans ledit moyen formant châssis (2) reposent totalement sur leurs piliers de planarisation correspondants (28) lesquels reposent au niveau supérieur de la plate-forme (48).

2. Moyen de transport selon la revendication 1, dans lequel les piliers de planarisation (28) agissent également en tant que moyens pour exposer le dessus et le dessous de chaque dispositif électrique (32) porté par chacune des unités porteuses (4;56).

3. Moyen de transport selon la revendication 1 ou 2, dans lequel le moyen (2) pour maintenir les unités porteuses (4;56) supporte les unités porteuses de sorte qu'elles soient uniformément orientées.

4. Moyen de transport selon les revendications 1, 2 ou 3, dans lequel le moyen (2) pour maintenir les unités porteuses comporte :
a) le moyen formant châssis (2),
b) un ensemble d'orifices se trouvant de façon générale dans le même plan (6) définis par le moyen formant châssis (2) dans lesquels les unités porteuses (4;56) sont disposées, et
c) des moyens (38,40) pour fixer les unités porteuses (4;56) dans leurs orifices respectifs (6) mais permettant aux unités porteuses (4;56) de flotter par rapport au plan de leurs orifices (6).

5. Moyen de transport selon la revendication 4, dans lequel les moyens (38,40) pour fixer les unités porteuses (4;56) dans leurs orifices respectifs (6) comportent :
a) un ensemble de moyens formant fourches (38) faisant saillie à partir d'une base de chacune des unités porteuses (4;56), chaque moyen formant fourche (38) comportant une extrémité fourchue élastique et susceptible d'être repliée radialement (40), et
b) un ensemble d'orifices d'accrochage correspondants (44) définis par le moyen formant châssis (2), la dimension de chaque orifice d'accrochage (44) étant inférieure aux dimensions d'une extrémité fourchue qui n'est pas repliée (40) d'un moyen formant fourche correspondant (38) mais étant suffisamment grande pour permettre le passage au travers de l'extrémité fourchue rabattue de telle sorte que les extrémités fourchues soient saisies lorsque le moyen formant fourche est inséré à l'intérieur de l'orifice d'accrochage (44).

6. Moyen de transport selon l'une quelconque des revendications précédentes, dans lequel chaque unité porteuse (4;56) comporte en outre :
a) un périmètre (54) qui est du même type que les périmètres des autres unités porteuses, et
b) un noyau (52) qui est spécialement conçu pour des dimensions et formes d'un dispositif électrique particulier.

7. Moyen de transport selon la revendication 6, dans lequel le noyau (26;57) comporte en outre :
a) un ou plusieurs sièges de dispositifs électriques (16;58) dans lesquels les dispositifs électriques (32) sont logés,
b) des moyens pour aligner une sonde de traitement avec les dispositifs électriques logés dans l'unité porteuse, et
c) une bordure fixée au périmètre de l'unité porteuse (54) pour maintenir le(s) siège(s) de dispositifs (16;58) et le moyen pour aligner une sonde de traitement en position fixe par rapport au noyau (52), l'ensemble des sièges de dispositifs étant fixé de façon à se trouver dans le même plan.

8. Moyen de transport selon la revendication 7, dans lequel chaque siège de dispositif électrique (16;58) comporte :
a) un fourreau formant siège qui correspond à une dimension et une forme marginale d'un dispositif électrique (32) qui est susceptible de se loger dans celui-ci,
b) un moyen d'arrêt (20) pénétrant à l'intérieur du fourreau formant siège pour limiter la profondeur selon laquelle le dispositif électrique (32) est logé, et
c) un ensemble de moyens formant crochets susceptibles de se rétracter élastiquement (18a,18b) opposés opérationnellement par rapport au moyen d'arrêt (20) pour saisir le dispositif électrique (32) entre eux.

9. Moyen de transport selon la revendication 4, dans lequel les orifices d'unités porteuses (6) sont disposés selon des coordonnées pour permettre aux unités porteuses qui y sont disposées d'être identifiables sans erreur par un ensemble de coordonnées et de plus comportent un moyen d'indexation de châssis (12) destiné à être utilisé par une machine de traitement pour localiser chaque unité porteuse individuelle en fonction de ses coordonnées.
